Europäisches Patentamt

European Patent Office

Office européen des brevets

(19)

(11) **EP 1 351 095 A2**

(12) **EUROPEAN PATENT APPLICATION**

(43) Date of publication:
08.10.2003 Bulletin 2003/41

(51) Int Cl.$^7$: **G03F 1/14**

(21) Application number: **03100867.5**

(22) Date of filing: **02.04.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK RO**

(30) Priority: **05.04.2002 GB 0207856**

(71) Applicant: **Zarlink Semiconductor Limited**
**Swindon, Wiltshire SN2 2QW (GB)**
Designated Contracting States:
**DE FR GB**

(72) Inventor: **Martin, Brian**
**PL6 6LQ, Plymouth (GB)**

(74) Representative: **Asquith, Julian Peter**
**Marks & Clerk,**
**4220 Nash Court,**
**Oxford Business Park South**
**Oxford OX4 2RU (GB)**

(54) **Reticles for MEMS and IC processes**

(57) A reticle for use in the production, using photo-lithography, of a MEMS or IC device containing one or more contact or via holes, comprises one or more apertures corresponding to said holes, and arranged to define said holes during the photo-lithography process, the reticle being characterised in that said apertures are substantially circular in shape.

## EXPOSURE LATITUDE vs CONTACT SIZE

◆ Square contact
■ Circular contact

**EP 1 351 095 A2**

**Description**

The invention relates to improvements in reticles for use in the production of MEMS (micro electo-mechanical systems) or IC (integrated circuit) devices containing contact or via holes, to an improved method of producing MEMS or IC devices, and to MEMS and IC devices produced by such a method.

According to the invention there is provided a reticle, method and MEMS or IC device as set out in the accompanying claims.

Embodiments of the invention will now be more particularly described, by way of example only, with reference to the accompanying single figure which shows a graph of exposure latitude versus contact size.

In IC processing contact is made by metal layers which connect to active circuit areas by contact holes defined in an oxide. When circuit complexity demands multi-layer metallisation, each layer is inter-connected by a via hole defined in an intermediate dielectric. MEMS circuits may require similar contacts to connect to underlying IC's or within their own architecture. Via holes are conventionally drawn as squares in the layout design as are contacts. Contacts connect metal to the active parts of the device rough an intermediate layer of oxide called the inter-layer dielectric (ILD). Via holes perform a similar function but are the means of interconnecting metal layers through an inter-metal dielectric (IMD) which is normally oxide or polyimide. Therefore via holes and contacts are similarly shaped and perform similar functions. In the IC industry, the interconnects are referred to as contacts at ILD and vias at IMD respectively.

When a designer has completed the layout for a circuit layer, the software which he uses to make the layout is able to output the information existing on that layer in a hierarchical format thus enabling the data to be compressed (for efficiency) as it is sent to the site where the reticle (mask) is to be made. Before the reticle can be written the data has to be de-compressed (sometimes called fracturing) so that all of the information can be "streamed" and input to the tool which writes the pattern on the reticle. Both the hierarchical data and the fractured data are commonly referred to as the data file.

Design Rules are the layout guidelines which are used by circuit designers. They exist at every layer (poly, contacts etc) and refer to the allowable size and spacing of features present on that layer. Design rules define contact or via features as squares and they are similarly defined in the data file which is used together with a laser or e-beam writer which defines the corresponding chrome pattern on a mask (often called a reticle). The mask is then used to define patterns on a wafer by means of optical lithography, usually by means of a 5X reduction lens so that mask patterns are 5X those on the wafer. However, when these square patterns in the data file are defined on the mask, their comers are not perfectly square, but become rounded. Degree of rounding is rather less on the higher resolution e-beam writers but, for a 5X reduction mask, is substantially independent of contact size. Typically corner rounding has a radius of 0.3 micron on 5X reticles.

As the resolution of a 5X reduction lens is approached, the fidelity of printed features is compromised and process control, as defined by exposure latitude (EL) shrinks. Much effort has been expended, through the use of optical proximity correction (OPC) software to address these problems, but there are situations where it may be financially unsound to resort to OPC and simpler approaches may be worthwhile. It is known that below a critical size, defined by the performance of the optical system, that contact or via holes, irrespective of their shape on the mask, will print as circles. This effect is explained through the Fourier optics approach to imaging where the lens behaves as a low-pass system thus rejecting the higher spatial frequencies required for the accurate reconstruction of near-square contacts as might be found on a "perfect" mask.

By purposely designing on-mask contact or via holes as circles, exposure latitude can be increased offering improved manufacturing margins and simultaneously easing the burden on reticle manufacture. Exposure latitude, EL, can be defined in a number of ways but here is:

$$EL = [\text{exposure for 10\% above target} - \text{exposure for 10\% below target}]/[\text{exposure to size}].$$

Exposure to size is that exposure which, after photoresist development, gives the same linewidth on the wafer as is on the reticle, allowing for demagnification of course. For example, using a 5X reduction lens, a line whose design is size 1 micron would be written on the reticle at 5 micron. The exposure to size is that exposure which gives a 1 micron line on the wafer.

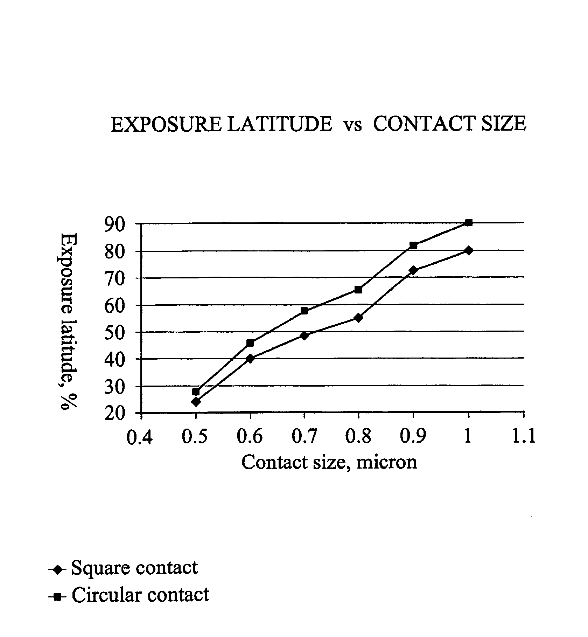

Figure 1 shows EL plotted vs contact size (1X) for square and circular contacts. The results are generated using a well -proven lithography model which supports all aspects of lithography processing. The optical system used in the calculation has a resolution limit for contacts of 0.5 micron. At the larger contact sizes EL is 5-10% better for the circular contacts but as the resolution limit of 0.5 micron is approached the plots converge and meet at 0.4 micron. At the smaller contact sizes the aerial image from the mask becomes similar irrespective of whether square or circular contacts are drawn.

Whilst shapes in data files are conventionally rectilinear, circular features can be made by approximating the circumference using over 100 linear features

The area of the contacts on the reticle are reduced resulting in an exposure increase but design rules are not violated.

**Claims**

1. A reticle for use in the production, using photo-lithography, of a MEMS or IC device containing one or more contact or via holes, the reticle comprising one or more apertures corresponding to said holes, and arranged to define said holes during the photo-lithography process, the reticle being **characterised in that** said apertures are substantially circular in shape.

2. A method of producing contact or via holes in a MEMS or IC device, comprising the steps of:

   covering the surface of a wafer with a layer of photoresist;

   providing a mask containing apertures above the wafer;

   exposing the mask with light so that a pattern is defined on the photoresist;

   developing and etching the photoresist in order to create a corresponding pattern on the wafer;

   the method being **characterised in that** said apertures provided in the mask are substantially circular.

3. A method as claimed in claim 2, wherein a 5 times reduction lens is used between the mask and the wafer.

4. A MEMS or IC device manufactured in accordance with the method of claim 2 or 3.

EXPOSURE LATITUDE vs CONTACT SIZE